(19) Europäisches Patentamt
European Patent Office
Office européen des brevets

(11) **EP 3 419 952 B1**

(12) **EUROPÄISCHE PATENTSCHRIFT**

(45) Veröffentlichungstag und Bekanntmachung des Hinweises auf die Patenterteilung:
**01.04.2020 Patentblatt 2020/14**

(21) Anmeldenummer: **17708988.5**

(22) Anmeldetag: **16.02.2017**

(51) Int Cl.:
*C04B 37/02* [(2006.01)]     *C04B 41/00* [(2006.01)]

(86) Internationale Anmeldenummer:
**PCT/EP2017/053451**

(87) Internationale Veröffentlichungsnummer:
**WO 2017/144333 (31.08.2017 Gazette 2017/35)**

(54) **KUPFER-KERAMIK-VERBUND**

COPPER- CERAMIC COMPOSITE

COMPOSITE CUIVRE-CERAMIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.02.2016 DE 102016203112**

(43) Veröffentlichungstag der Anmeldung:
**02.01.2019 Patentblatt 2019/01**

(73) Patentinhaber: **Heraeus Deutschland GmbH & Co. KG**
**63450 Hanau (DE)**

(72) Erfinder:
• **HERBST, Kai**
**91056 Erlangen (DE)**
• **MUSCHELKNAUTZ, Christian**
**64347 Griesheim (DE)**
• **ROGG, Alexander**
**92724 Trabitz (DE)**

(74) Vertreter: **Haggenmüller, Christian**
**Maiwald Patentanwalts- und Rechtsanwaltsgesellschaft mbH**
**Elisenhof**
**Elisenstraße 3**
**80335 München (DE)**

(56) Entgegenhaltungen:
**DE-A1-102004 050 792     JP-A- 2014 222 619**

**Beschreibung**

Die vorliegende Erfindung betrifft einen Kupfer-Keramik-Verbund sowie ein diesen Verbund enthaltendes Modul, das in Leistungselektronikbauteilen verwendet werden kann.

Keramikschaltungsträger sind aufgrund ihrer hohen Wärmeleitfähigkeit, hohen Formstabilität bzw. mechanischen Festigkeit sowie ihrer hohen Isolationsfestigkeit insbesondere im Bereich der Hochleistungselektronik von Interesse.

Für die Metallisierung eines Keramiksubstrats stehen verschiedene Verfahren wie z.B. Direct-Copper-Bonding (üblicherweise als DCB-Verfahren bezeichnet) oder Active-Metal-Brazing (üblicherweise als AMB-Verfahren bezeichnet) zur Verfügung.

Das nach der Metallisierung des Keramiksubstrats erhaltene Verbundmaterial wird auch als Metall-Keramik-Substrat oder Metall-Keramik-Verbund bezeichnet. Sofern es beispielsweise durch ein DCB-Verfahren hergestellt wurde, wird häufig auch die Bezeichnung "DCB-Substrat" verwendet.

Bei dem DCB-Verfahren wird ausgenutzt, dass Sauerstoff den Schmelzpunkt des Kupfers von 1083°C auf die eutektische Schmelztemperatur von 1065°C reduziert. Durch die Oxidation von Kupferfolien vor der Metallisierung des Keramiksubstrates oder durch Sauerstoffzufuhr während des Hochtemperaturprozesses (beispielsweise bei einer Temperatur zwischen 1065°C und 1080°C) entsteht eine dünne eutektische Schmelzschicht. Diese reagiert mit der Oberfläche des Keramiksubstrats, so dass Keramik und Metall haftfest miteinander verbunden werden können.

DCB-Verfahren werden beispielsweise in US 3,744,120 oder DE 23 19 854 beschriebenen.

Die Metallisierung kann beispielsweise nur auf einer Seite des Keramiksubstrats ("Single-Layer-Bonding" SLB) oder alternativ auch auf beiden Seiten des Keramiksubstrates gleichzeitig ("Double-Layer-Bonding" DLB) erfolgen. Außerdem ist es möglich, zunächst eine erste Seite des Substrats durch einen ersten SLB-Schritt zu metallisieren und anschließend auch die gegenüberliegende Substratseite in einem weiteren SLB-Schritt zu metallisieren.

Bekannt ist auch, die aufgebrachte Metallbeschichtung für die Ausbildung von Leiterbahnen zu strukturieren, beispielsweise über Ätzverfahren.

In vielen Anwendungen der Leistungselektronik unterliegt der Metall-Keramik-Verbund hohen Temperaturwechselbelastungen, bei denen deutliche Temperaturänderungen (z.B. im Bereich zwischen -40°C und +150°C) auftreten können.

Bedingt durch die unterschiedlichen Wärmeausdehnungskoeffizienten des Keramiksubstrats und der Metallbeschichtung ergeben sich am Übergang zwischen diesen Schichten bei Temperaturschwankungen erhebliche mechanische Spannungen, die letztlich zu einer zumindest partiellen Ablösung des Metalls von der Keramikoberfläche führen können. Bekannt ist, dass durch eine spezifische Strukturierung der Metallschicht auf makroskopischer Ebene in ihrem Randbereich Zug- und Druckspannungen verringert und somit die Temperaturwechselbeständigkeit verbessert werden kann. DE 40 04 844 und DE4318241 A1 beschreiben Metallbeschichtungen auf Keramiksubstraten, die an ihren Kanten Randabschwächungen in Form von Vertiefungen oder Löchern aufweisen.

Neben der Temperaturwechselbeständigkeit sind weitere relevante Eigenschaften eines Kupfer-Keramik-Verbunds für Anwendungen in der Elektronik dessen, Wärmeleitfähigkeit und mechanische Festigkeit (insbesondere die Wärmeleitfähigkeit und mechanische Festigkeit des Keramiksubstrats), ein gutes Bondingverhalten der Kupferbeschichtung gegenüber Bondingdrähten sowie eine möglichst feste Bindung der Metallbeschichtung an die Keramikoberfläche, wobei diese Bindung auch unter längeren Temperaturwechselbelastungen ausreichend fest bleibt sollte.

In der DE 10 2012 110 322 wird das Keramiksubstrat des Metall-Keramik-Verbunds hinsichtlich seiner Kornstruktur (also seiner Struktur auf mikroskopischer Ebene) eingehender definiert. Das Keramiksubstrat enthält ein mit Zirkonoxid verstärktes Aluminiumoxid, wobei die mittlere Korngröße des Aluminiumoxids im Bereich von 2-8 $\mu$m liegt und das Verhältnis der Länge der Korngrenzen der $Al_2O_3$-Körner zu der Gesamtlänge aller Korngrenzen >0,6 ist. Nach den Angaben der DE 10 2012 110 322 trägt diese Kornstruktur zur Verbesserung der Wärmeleitfähigkeit bei.

DE102004050792 betrifft ein Bauelemente-Modul für Hochtemperaturanwendungen. Das Modul enthält eine Grundplatte, auf der ein mehrlagiger Stapel unterschiedlicher Materialien aufgebracht ist. Dieser mehrlagige Stapel enthält unter anderem zwei Keramikplatten, die jeweils an ihrer Ober- und Unterseite eine Metallbeschichtung aufweisen. Es handelt sich bei dem Metall um Kupfer, das über ein DCB Verfahren auf die Keramikplatte aufgebracht wird.

Eine Aufgabe der vorliegenden Erfindung liegt in der Bereitstellung eines Metall-Keramik-Verbunds mit verbessertem Eigenschaftsprofil, insbesondere mit verbesserter Temperaturwechselbeständigkeit.

Gelöst wird die Aufgabe durch einen Kupfer-Keramik-Verbund, umfassend

- ein Keramiksubstrat, das Aluminiumoxid enthält,
- eine auf dem Keramiksubstrat vorliegende Beschichtung aus Kupfer oder einer Kupferlegierung, die über ein DCB-Verfahren auf das Keramiksubstrat aufgebracht wird,

wobei

die Körner des Aluminiumoxids jeweils einen maximalen Durchmesser $d_{Kmax}$, einen senkrecht zu $d_{K,max}$ verlaufenden Durchmesser $d_{K,ortho}$, bestimmt auf halber Länge von $d_{K,max}$, und einen Formfaktor $R_K(Al_2O_3)= d_{K,ortho} / d_{K,max}$ aufweisen und das Aluminiumoxid einen mittleren Korn-Formfaktor $R_a(Al_2O_3)$, bestimmt als arithmetischer Mittelwert aus den Formfaktoren $R_K(Al_2O_3)$ der Körner des Aluminiumoxids, aufweist,

die Körner des Kupfers oder der Kupferlegierung jeweils einen maximalen Durchmesser $d_{K,max}$, einen senkrecht zu $d_{K,max}$ verlaufenden Durchmesser $d_{K,ortho}$, bestimmt auf halber Länge von $d_{K,max}$, und einen Formfaktor $R_K(Cu)= d_{K,ortho} / d_{K,max}$ aufweisen und das Kupfer oder die Kupferlegierung einen mittleren Korn-Formfaktor $R_a(Cu)$, bestimmt als arithmetischer Mittelwert aus den Formfaktoren $R_K(Cu)$ der Körner des Kupfers oder der Kupferlegierung, aufweist,

wobei die mittleren Korn-Formfaktoren des Aluminiumoxids und des Kupfers oder der Kupferlegierung der folgenden Bedingung genügen:

$$0,5 \leq R_a(Al_2O_3) / R_a(Cu) \leq 2,0.$$

Sowohl bei der Kupferbeschichtung als auch beim Keramiksubstrat eines Kupfer-Keramik-Verbunds handelt es sich allgemein um ein polykristallines Material, das aus kleinen Kristalliten (die auch als Körner bezeichnet werden) besteht. Auf mikroskopischer Ebene können polykristalline Materialien anhand ihrer Kornstruktur (z.B. Korngrößenverteilungen, Form der Körner, Textur, .... etc.) eingehender charakterisiert werden.

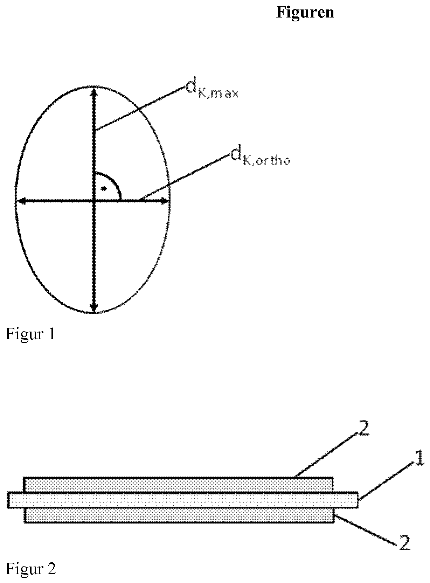

Die Form eines individuellen Korns lässt sich über seinen Formfaktor $R_K$ ausdrücken, der das Verhältnis des maximalen Korndurchmessers $d_{K,max}$ zu dem senkrecht zu $d_{K,max}$ verlaufenden Durchmesser $d_{K,ortho}$, bestimmt auf halber Länge von $d_{K,max}$, ist (d.h. $R_K=d_{K,ortho}/d_{K,max}$). Dies ist schematisch in Figur 1 anhand eines Korns mit elliptischer Kornstruktur dargestellt.

Aus dem arithmetischen Mittelwert der Formfaktoren $R_K$ der Körner erhält man den mittleren Korn-Formfaktor $R_a$ des Materials. Enthält ein Material beispielsweise einen hohen Anteil länglicher Körner, so wird der mittlere Korn-Formfaktor dieses Materials einen relativ niedrigen Wert einnehmen. Andererseits gilt, dass sich der mittlere Korn-Formfaktor umso mehr dem Wert 1,0 annähert, je höher der Anteil von runden, kreisförmigen Körnern ist.

Im Rahmen der vorliegenden Erfindung wurde überraschend festgestellt, dass sich die Temperaturwechselbeständigkeit eines Kupfer-Keramik-Verbunds verbessern lässt, wenn sich die Körner des Kupfers oder der Kupferlegierung der Metallbeschichtung und die Körner des Aluminiumoxids des Keramiksubstrats in ihrer Form ähnlich sind und daher die mittleren Korn-Formfaktoren des Aluminiumoxids und des Kupfers oder der Kupferlegierung der folgenden Bedingung genügen:

$$0,5 \leq R_a(Al_2O_3) / R_a(Cu) \leq 2,0.$$

Erfindungsgemäß versteht man unter einer Temperaturwechselbeständigkeit den Widerstand bzw. die Widerstandsfähigkeit der Kupferschicht gegen Delamination von der Keramik eines Kupfer-Keramik-Substrates, wobei der Widerstand in Folge von zumindest einem Temperaturwechsel der Kupferschicht gegenüber der Keramik bestimmt wird. Eine verbesserte Temperaturwechselbeständigkeit bedeutet, dass die Anzahl der widerstandenen Temperaturwechsel sich vergrößert.

Erfindungsgemäß wird unter einem verbesserten Drahtbonding verstanden, dass die Kraft, mit der der Bonddraht von der Kupferoberfläche eines Kupfer-Keramik-Verbundes abgelöst werden kann, erhöht ist.

Erfindungsgemäß wird unter einer verbesserten Kupferhaftfestigkeit eine Haftfestigkeit des Kupfers gegenüber dem Kupfer-Keramik-Verbundes verstanden, so dass die Kraft, mit der die gebondete Kupferfolie von der Keramikoberfläche eines Kupfer-Keramik-Verbundes abgelöst werden kann, erhöht ist. Aus der DE102004012231B4 ist dem Fachmann ein beispielhaftes Meßverfahren bekannt (Figuren 2 und 3 der DE102004012231B4).

Erfindungsgemäß wird unter einer verbesserten Biegebruchfestigkeit der Keramik verstanden, dass bei einer Drei-Punkt-Biegung die zum Bruch führende Kraft erhöht ist. Dem Fachmann ist beispielsweise zur Biegebruchfestigkeitsbestimmung der Keramik die DIN EN 843-1 (2008). Bevorzugt weicht die Probengeometrie gegenüber der DIN EN 843-1 (2008) dahingehend ab, dass die Proben eine Abmessung von 20 x 40 x 0,38 mm$^3$ oder 20 x 40 x 0,63 mm$^3$ aufweisen.

Bevorzugt liegt das Verhältnis des mittleren Korn-Formfaktors des Aluminiumoxids zu dem mittleren Korn-Formfaktor des Kupfers oder der Kupferlegierung im Bereich von 0,75-1,50, bevorzugter im Bereich von 0,80-1,20.

Bevorzugt ist der mittlere Korn-Formfaktor $R_a(Al_2O_3)$ des Aluminiumoxids $\geq 0,40$, noch bevorzugter $\geq 0,60$ oder $\geq 0,80$; und der mittlere Korn-Formfaktor $R_a(Cu)$ des Kupfers oder der Kupferlegierung ist bevorzugt $\geq 0,40$, noch bevorzugter $\geq 0,60$ oder $\geq 0,80$; unter der Maßgabe, dass das Verhältnis $R_a(Al_2O_3) / R_a(Cu)$ den oben genannten Bedingungen genügt.

Im Rahmen der Erfindung konnte ferner festgestellt werden, dass durch Auswahl weiterer Produktparameter Produkteigenschaften verbessert werden konnten.

Bevorzugt liegen die Korngrößen des Kupfers oder der Kupferlegierung im Bereich von 10 $\mu$m bis 300 $\mu$m, bevorzugter im Bereich von 15 $\mu$m bis 250 $\mu$m, noch bevorzugter im Bereich von 20 $\mu$m bis 210 $\mu$m. In diesem Korngrößenbereich zeigt das Kupfer oder die Kupferlegierung auch dann noch eine gute Haftung auf einem Keramiksubstrat, wenn der Kupfer-Keramik-Verbund häufigen Temperaturwechselbelastungen ausgesetzt ist. Gleichzeitig ermöglicht das Kupfer oder die Kupferlegierung mit diesen Korngrößen ein effizientes Drahtbonding. Eine Metallbeschichtung zeigt ein gutes Drahtbonding, wenn sich eine möglichst starke Verbindung zu einem Bonddraht ausbilden lässt und dadurch das Risiko einer unerwünschten Ablösung des Bonddrahts minimiert wird. Im Rahmen der vorliegenden Erfindung sind diese Werte nicht als strikte Unter- und Obergrenzen für die Korngrößenverteilung anzusehen, sondern können um +/- 10% variieren. In einer bevorzugten Ausführungsform handelt es sich jedoch um die Unter- und Obergrenzen der Korngrößenverteilung des Kupfers oder der Kupferlegierung, die nicht unter- bzw. überschritten werden. In dieser bevorzugten Ausführungsform weist daher das Kupfer oder die Kupferlegierung keine Körner auf, die außerhalb der oben genannten Bereiche liegen. Es ist also bevorzugt, dass $d_{min}(Cu) \geq 10$ $\mu$m und $d_{max}(Cu) \leq 300$ $\mu$m, bevorzugter $d_{min}(Cu) \geq 15$ $\mu$m und $d_{max}(Cu) \leq 250$ $\mu$m, noch bevorzugter $d_{min}(Cu) \geq 20$ $\mu$m und $d_{max}(Cu) \leq 210$ $\mu$m, wobei $d_{min}(Cu)$ und $d_{max}(Cu)$ die minimalen bzw. maximalen Korngrößen des Kupfers sind.

Durch Verwendung einer Kupferausgangsfolie mit geeigneter Korngrößenverteilung können die gewünschten Korngrößen im Kupfer-Keramik-Verbund eingestellt werden. Solche Kupferfolien sind kommerziell erhältlich oder können über Standardverfahren erhalten werden. Eine Feineinstellung der Korngrößen kann gegebenenfalls durch eine thermische Behandlung der Ausgangsfolie erfolgen.

Wie dem Fachmann grundsätzlich bekannt ist, kann die Bestimmung der Korngrößenverteilung unter Bezugnahme auf die Anzahl der Körner (d.h. Anzahlverteilung) oder alternativ auch unter Bezugnahme auf die Masse (d.h. Massenverteilung) oder das Volumen der Körner erfolgen. Im Rahmen der vorliegenden Erfindung wird die Verteilung der Korngrößen auf Basis der Körneranzahl bestimmt.

In einer bevorzugten Ausführungsform weist das Kupfer oder die Kupferlegierung eine Anzahlverteilung der Korngrößen auf, in der höchstens 5% der Körner eine Korngröße von weniger als 15 $\mu$m, bevorzugt weniger als 20 $\mu$m, noch bevorzugter weniger als 25 $\mu$m aufweisen; und/oder in der mindestens 95% der Körner eine Korngröße von weniger als 250 $\mu$m, bevorzugt weniger als 230 $\mu$m, noch bevorzugter weniger als 200 $\mu$m aufweisen.

Wie allgemein bekannt ist, sind charakteristische Werte einer Korngrößenverteilung unter anderem deren $d_{50}$-Wert, $d_5$-Wert und $d_{95}$-Wert. Für den $d_{50}$-Wert, der häufig auch als Medianwert bezeichnet wird, gilt Folgendes: 50% der Körner weisen einen Durchmesser auf, der kleiner ist als der $d_{50}$-Wert.

Analog gilt für den $d_5$-Wert, dass 5% der Körner einen Durchmesser aufweisen, der kleiner ist als dieser $d_5$-Wert, und für den $d_{95}$-Wert gilt, dass 95% der Körner einen Durchmesser aufweisen, der kleiner ist als dieser $d_{95}$-Wert.

Der arithmetische Mittelwert $d_{arith}$ einer Korngrößenverteilung ergibt sich aus der Summe der Korngrößen der einzelnen Körner dividiert durch die Körneranzahl.

Bevorzugt weist die Anzahlverteilung der Korngrößen des Kupfers oder der Kupferlegierung einen $d_{95}$-Wert von $\leq 250$ $\mu$m, bevorzugter im Bereich von 140 $\mu$m bis 250 $\mu$m, noch bevorzugter im Bereich von 140 $\mu$m bis 230 $\mu$m, noch weiter bevorzugt im Bereich von 150 $\mu$m bis 200 $\mu$m auf. Der $d_5$-Wert der Korngrößen-Anzahlverteilung des Kupfers oder der Kupferlegierung ist bevorzugt $\geq 15$ $\mu$m; bevorzugter liegt der $d_5$-Wert im Bereich von 15 $\mu$m bis 80 $\mu$m, noch bevorzugter im Bereich von 20 $\mu$m bis 75 $\mu$m, noch weiter bevorzugt im Bereich von 25 $\mu$m bis 70 $\mu$m. Damit kann eine weitere Optimierung der Temperaturwechselbeständigkeit und des Bondingverhaltens des Kupfers oder der Kupferlegierung erzielt werden.

Ein bevorzugter $d_{50}$-Wert der Korngrößen-Anzahlverteilung des Kupfers oder der Kupferlegierung liegt beispielsweise im Bereich von 55 $\mu$m bis 115 $\mu$m.

Im Rahmen der vorliegenden Erfindung kann es bevorzugt sein, dass die ds-, $d_{95}$- und dso-Werte der Korngrößen-Anzahlverteilung des Kupfers oder der Kupferlegierung so gewählt werden, dass sie der folgenden Bedingung genügen:

$$4,0 \geq (d_{95} - d_5)/d_{50} \geq 0,5$$

Die Symmetrie einer Korngrößenverteilung kann über das Verhältnis von Medianwert $d_{50}$ zu dem arithmetischen Mittelwert $d_{arith}$ dieser Verteilung ausgedrückt werden (d.h. durch den Quotienten $d_{50}/d_{arith}$; nachfolgend auch als Symmetriewert S bezeichnet). Je näher der Symmetriewert bei 1,0 liegt, desto symmetrischer ist die Korngrößenverteilung. In einer bevorzugten Ausführungsform weist das Kupfer oder die Kupferlegierung eine Anzahlverteilung der Korngrößen mit einem Medianwert $d_{50}$ und einem arithmetischen Mittelwert $d_{arith}$ auf, wobei das Verhältnis von $d_{50}$ zu $d_{arith}$ (d.h. $d_{50}/d_{arith}$) im Bereich von 0,75 bis 1,10, bevorzugter im Bereich von 0,78 bis 1,05, noch bevorzugter im Bereich von 0,80 bis 1,00 liegt. Damit kann eine weitere Optimierung der Temperaturwechselbeständigkeit und der Drahtbondingeigenschaften erzielt werden. Geeignete Methoden, mit denen die Symmetrie der Korngrößenverteilung im Kupfer, beispielsweise bereits in der Kupferausgangsfolie, eingestellt werden können, sind dem Fachmann bekannt. Beispielsweise kann die Symmetrie der Korngrößenverteilung in einer Kupferfolie durch eine geeignete Verarbeitungstemperatur oder einen Walzprozess beeinflusst werden. Kupferausgangsfolien, mit denen im finalen Kupfer-Keramik-Verbund die oben angegebenen Symmetriewerte realisiert werden können, sind kommerziell erhältlich oder können über Standardverfahren erhalten werden.

Die Breite der Korngrößenverteilung kann durch das Verhältnis von $d_5$-Wert zu $d_{95}$-Wert ausgedrückt werden. In einer bevorzugten Ausführungsform weist das Kupfer oder die Kupferlegierung eine Anzahlverteilung der Korngrößen mit einem $d_5$-Wert und einem $d_{95}$-Wert auf, wobei das Verhältnis von $d_5$ zu $d_{95}$ im Bereich von 0,1 bis 0,4, bevorzugter im Bereich von 0,11 bis 0,35, noch bevorzugter im Bereich von 0,12 bis 0,30 liegt. Damit kann eine weitere Optimierung der Temperaturwechselbeständigkeit und der Drahtbondingeigenschaften erzielt werden.

Bevorzugt ist der mittlere Korn-Formfaktor $R_a(Cu)$ des Kupfers oder der Kupferlegierung $\geq 0{,}40$, noch bevorzugter $\geq 0{,}60$ oder $\geq 0{,}80$. Geeignete Methoden, mit denen die Form der Körner im Kupfer, beispielsweise bereits in der Kupferausgangsfolie, eingestellt werden können, sind dem Fachmann bekannt. Beispielsweise kann die Kornform in einer Kupferfolie durch eine geeignete Verarbeitungstemperatur oder einen Walzprozess beeinflusst werden. Kupferausgangsfolien, mit denen im finalen Kupfer-Keramik-Verbund der oben angegebene mittlere Korn-Formfaktor $R_a(Cu)$ realisiert werden kann, sind kommerziell erhältlich oder können über Standardverfahren erhalten werden.

Eine geeignete Dicke der Beschichtung aus Kupfer oder einer Kupferlegierung in einem Kupfer-Keramik-Verbund ist dem Fachmann bekannt. Wie nachfolgend noch erläutert, kann an einigen Stellen der Beschichtung, insbesondere in Randbereichen, ein Teil des Kupfers oder der Kupferlegierung wieder abgetragen werden, beispielsweise zur Ausbildung von Randabschwächungen. Daher ist es im Rahmen der vorliegenden Erfindung möglich, dass die Dicke der Metallbeschichtung variiert. Üblicherweise weist die Beschichtung aus Kupfer oder einer Kupferlegierung über mindestens 70% ihrer Fläche eine Dicke im Bereich von 0.2-1.2 mm auf. Beispielsweise ist es möglich, dass die Dicke etwa 300 $\mu$m beträgt.

Bevorzugt sind die Dicke der Beschichtung aus Kupfer oder einer Kupferlegierung ($D_{Cu}$) und der Medianwert $d_{50}$ der Korngrößen-Anzahlverteilung des Kupfers oder der Kupferlegierung so ausgewählt, dass das Verhältnis $D_{Cu}$ zu $d_{50}$ im Bereich von 0.05 bis 0.40 liegt. Hierzu wird die Dicke $D_{Cu}$ des Kupfers oder der Kupferlegierung an einer Stelle der Beschichtung bestimmt und durch den Medianwert $d_{50}$ der Korngrößen-Anzahlverteilung des Kupfers oder der Kupferlegierung dividiert. Bevorzugt liegt das Verhältnis $D_{Cu}/d_{50}$ über mindestens 70%, bevorzugter mindestens 90% der Fläche der Beschichtung aus Kupfer oder einer Kupferlegierung im Bereich von 0,05 bis 0,40.

Bevorzugt weist das Kupfer der Beschichtung eine Reinheit von $\geq 99{,}50\%$, bevorzugter $\geq 99{,}90\%$, noch bevorzugter $\geq 99{,}95\%$ oder sogar $\geq 99{,}99\%$ auf.

Die Beschichtung wird aus Kupfer oder einer Kupferlegierung über ein DCB-Verfahren auf das Keramiksubstrat aufgebracht. Wie bereits oben erläutert, kann ein übliches DCB-Verfahren beispielsweise folgende Verfahrensschritte aufweisen:

- Oxidieren einer Kupferfolie, so dass sich an deren Oberfläche eine Kupferoxidschicht bildet;
- Auflegen der Kupferfolie mit der Kupferoxidschicht auf das Keramiksubstrat;
- Erhitzen des Verbundes auf eine Temperatur < 1083°C (z.B. eine Temperatur im Bereich von 1065-1080°C),
- Abkühlen auf Raumtemperatur.

Als Folge des DCB-Verfahrens können zwischen der Beschichtung aus Kupfer oder einer Kupferlegierung und dem Keramiksubstrat Spinellkristallite vorliegen (z.B. Kupfer-Aluminium-Spinelle).

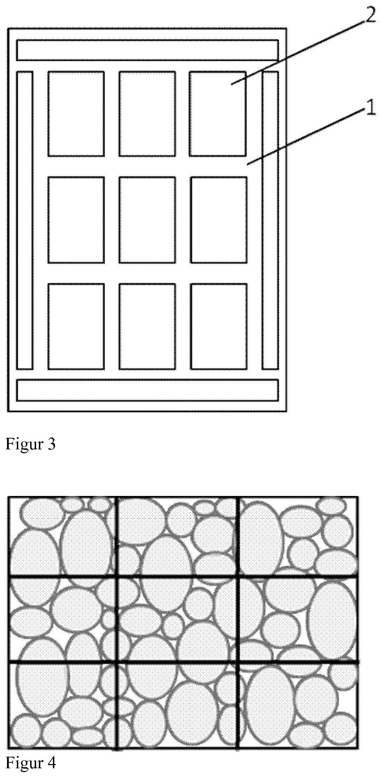

Die Beschichtung aus Kupfer oder einer Kupferlegierung kann beispielsweise nur auf einer Seite des Keramiksubstrats angebracht sein. Alternativ ist es möglich, dass beide Seiten (d.h. Ober- und Unterseite) des Keramiksubstrats mit der Beschichtung aus Kupfer oder einer Kupferlegierung versehen sind. Ein beispielhafter Kupfer-Keramik-Verbund, bei dem ein Keramiksubstrat 1 sowohl an seiner Unter- wie auch an seiner Oberseite eine Beschichtung 2 aus Kupfer oder einer Kupferlegierung aufweist, wird in Figur 2 gezeigt. Ein beispielhafter Kupfer-Keramik-Verbund, bei dem das Keramiksubstrat 1 mehrere Bereiche aufweist, die jeweils mit einer Beschichtung 2 aus Kupfer oder Kupferlegierung versehen sind, wird in Figur 3 gezeigt. Wie nachfolgend noch erläutert wird, können die einzelnen metallisierten Bereiche durch Sollbruchlinien (nicht gezeigt in Figur 3) voneinander getrennt sein, so dass durch Brechen entlang dieser Sollbruchlinien eine Vereinzelung dieser Bereiche erfolgen kann.

Zur Ausbildung elektrischer Kontaktflächen kann die Beschichtung aus Kupfer oder einer Kupferlegierung zumindest teilweise eine Strukturierung aufweist. Die Strukturierung der Metallbeschichtung kann in bekannter Weise erfolgen, insbesondere über ein Ätzverfahren (beispielsweise unter Verwendung einer Ätzmaske).

In dem Ätzverfahren kann das Kupfer oder die Kupferlegierung in Teilbereichen vollständig entfernt werden, so dass in diesen Teilbereichen die Oberfläche des Keramiksubstrats freigelegt wird. Weiterhin ist es auch möglich, dass die Beschichtung aus Kupfer oder einer Kupferlegierung eine oder mehrere Vertiefungen (bevorzugt runde Vertiefungen) aufweist, die beispielsweise in dem Ätzverfahren dadurch erhalten werden, dass beispielsweise das Kupfer oder die Kupferlegierung in dem Bereich der anzubringenden Vertiefung nur teilweise entfernt und die Oberfläche des Keramiksubstrats in diesem Bereich daher noch mit Kupfer oder Kupferlegierung belegt ist. Alternativ oder ergänzend ist es möglich, die Vertiefungen durch das Kupfer oder die Kupferlegierung hindurch bis auf die Keramikoberfläche freizuätzen. Hinsichtlich der möglichen Anordnung solcher Vertiefungen, bevorzugt im Randbereich der Beschichtungen aus Kupfer oder Kupferlegierung, kann beispielsweise auf DE 40 04 844 C1 und DE 43 18 241 A1 verwiesen werden.

Wie oben ausgeführt, enthält das Keramiksubstrat Aluminiumoxid ($Al_2O_3$).

Bevorzugt liegen die Korngrößen des Aluminiumoxids im Bereich von 0,01 $\mu$m bis 25 $\mu$m, bevorzugter im Bereich von 0,3 $\mu$m bis 23 $\mu$m, noch bevorzugter im Bereich von 0,5 $\mu$m bis 20 $\mu$m. Mit Korngrößen in diesen Bereich weist das Keramiksubstrat des Kupfer-Keramik-Verbunds sowohl eine hohe mechanische Festigkeit als auch eine hohe Wärmeleitfähigkeit auf. Im Rahmen der vorliegenden Erfindung sind diese Werte nicht als strikte Unter- und Obergrenzen für die Korngrößenverteilung anzusehen, sondern können um +/- 10% variieren. In einer bevorzugten Ausführungsform handelt es sich jedoch um die Untergrenze, die nicht unterschritten wird, und Obergrenzen, die nicht überschritten wird, der Korngrößenverteilung des Aluminiumoxids. In dieser bevorzugten Ausführungsform weist daher das Aluminiumoxid keine Körner auf, die außerhalb der oben genannten Bereiche liegen. Es ist also bevorzugt, dass $d_{min}(Al_2O_3) \geq 0,01$ $\mu$m und $d_{max}(Al_2O_3) \leq 25$ $\mu$m, bevorzugter $d_{min}(Al_2O_3) \geq 0,3$ $\mu$m und $d_{max}(Al_2O_3) \leq 23$ $\mu$m, noch bevorzugter $d_{min}(Al_2O_3)$ $\geq 0,5$ $\mu$m und $d_{max}(Al_2O_3) \leq 20$ $\mu$m, wobei $d_{min}(Al_2O_3)$ und $d_{max}(Al_2O_3)$ die minimalen bzw. maximalen Korngrößen des Aluminiumoxids sind.

Durch Verwendung eines Keramik-Ausgangsmaterials mit geeigneter $Al_2O_3$-Korngrößenverteilung können die gewünschten $Al_2O_3$-Korngrößen im Kupfer-Keramik-Verbund eingestellt werden. Solche Keramikmaterialien sind kommerziell erhältlich oder können über Standardverfahren erhalten werden. Eine Feineinstellung der Korngrößen kann gegebenenfalls durch eine thermische Behandlung des Keramik-Ausgangsmaterials erfolgen.

Wie oben bereits erwähnt, wird im Rahmen der vorliegenden Erfindung die Verteilung der Korngrößen auf Basis der Körneranzahl bestimmt (d.h. Korngrößen-Anzahlverteilung).

In einer bevorzugten Ausführungsform weist das Aluminiumoxid des Keramiksubstrats eine Anzahlverteilung der Korngrößen auf, in der höchstens 5% der Körner eine Korngröße von weniger als 0,1 $\mu$m, bevorzugter weniger als 0,3 $\mu$m, noch bevorzugter weniger als 0,5 $\mu$m aufweisen; und/oder in der mindestens 95% der Körner eine Korngröße von weniger als 15 $\mu$m, bevorzugter weniger als 10 $\mu$m, noch bevorzugter weniger als 7 $\mu$m aufweisen.

Eine weitere Optimierung der mechanischen Festigkeit und der Wärmeleitfähigkeit des Keramiksubstrats in dem Metall-Keramik-Verbund kann erzielt werden, wenn die $d_5$- und $d_{95}$-Werte der Korngrößenverteilung des $Al_2O_3$ bestimmten Anforderungen genügen.

Bevorzugt weist die Anzahlverteilung der Korngrößen des Aluminiumoxids einen $d_{95}$-Wert von $\leq 15,0$ $\mu$m, bevorzugter im Bereich von 4,0 $\mu$m bis 15,0 $\mu$m, noch bevorzugter im Bereich von 4,5 $\mu$m bis 10,0 $\mu$m, noch weiter bevorzugt im Bereich von 5,0 $\mu$m bis 8,0 $\mu$m auf. Der $d_5$-Wert der Korngrößen-Anzahlverteilung des Aluminiumoxids ist bevorzugt $\geq 0,1$ $\mu$m; bevorzugter liegt der $d_5$-Wert im Bereich von 0,1 $\mu$m bis 2,5 $\mu$m, noch bevorzugter im Bereich von 0,3 $\mu$m bis 2,5 $\mu$m, noch weiter bevorzugt im Bereich von 0,5 $\mu$m bis 2,0 $\mu$m. Damit kann eine weitere Optimierung der mechanischen Festigkeit und der Wärmeleitfähigkeit des Keramiksubstrats in dem Metall-Keramik-Verbund erzielt werden.

Ein bevorzugter $d_{50}$-Wert der Korngrößen-Anzahlverteilung des Aluminiumoxids liegt beispielsweise im Bereich von 1,0 $\mu$m bis 3,0 $\mu$m.

Im Rahmen der vorliegenden Erfindung kann es bevorzugt sein, dass die ds-, $d_{95}$- und dso-Werte der Korngrößen-Anzahlverteilung des Aluminiumoxids so gewählt werden, dass sie der folgenden Bedingung genügen:

$$9,5 \geq (d_{95} - d_5)/d_{50} \geq 0,7$$

In einer bevorzugten Ausführungsform weist das Aluminiumoxid eine Anzahlverteilung der Korngrößen mit einem Medianwert $d_{50}$ und einem arithmetischen Mittelwert $d_{arith}$ auf, wobei das Verhältnis von $d_{50}$ zu $d_{arith}$ (d.h. $d_{50}/d_{arith}$; nachfolgend auch als Symmetriewert $S(Al_2O_3)$ der Korngrößen-Anzahlverteilung des Aluminiumoxids bezeichnet)) im Bereich von 0,75 bis 1,10, bevorzugter im Bereich von 0,78 bis 1,05, noch bevorzugter im Bereich von 0,80 bis 1,00 liegt. Damit kann eine weitere Optimierung der mechanischen Festigkeit und Wärmeleitfähigkeit des Keramiksubstrats im Metall-Keramik-Verbund erzielt werden.

Geeignete Methoden, mit denen die Symmetrie der Korngrößenverteilung im Aluminiumoxid, beispielsweise bereits bei der Herstellung des Ausgangssubstrats, eingestellt werden können, sind dem Fachmann bekannt. Beispielsweise kann die Symmetrie der Korngrößenverteilung durch Sinterdauer und Sintertemperatur bei der Herstellung des Ausgangssubstrats beeinflusst werden. $Al_2O_3$-Substrate, mit denen im finalen Kupfer-Keramik-Verbund die oben angegebenen Symmetriewerte realisiert werden können, sind kommerziell erhältlich oder können über Standardverfahren erhalten werden.

Die Breite der Korngrößenverteilung kann durch das Verhältnis von $d_5$-Wert zu $d_{95}$-Wert ausgedrückt werden. In einer bevorzugten Ausführungsform weist das Aluminiumoxid eine Anzahlverteilung der Korngrößen mit einem $d_5$-Wert und einem $d_{95}$-Wert auf, wobei das Verhältnis von $d_5$ zu $d_{95}$ im Bereich von 0,1 bis 0,4, bevorzugter im Bereich von 0,11 bis 0,35, noch bevorzugter im Bereich von 0,12 bis 0,30 liegt. Damit kann eine weitere Optimierung der mechanischen Festigkeit und Wärmeleitfähigkeit des Keramiksubstrats im Metall-Keramik-Verbund erzielt werden.

Bevorzugt ist der mittlere Korn-Formfaktor $R_a(Al_2O_3)$ des Aluminiumoxids $\geq 0{,}40$, bevorzugter $\geq 0{,}60$, noch bevorzugter $\geq 0{,}80$. Wie oben bereits erläutert, lässt sich die Form eines individuellen Korns über seinen Formfaktor $R_K$ ausdrücken, der das Verhältnis des maximalen Korndurchmessers $d_{K,max}$ zu dem senkrecht zu $d_{K,max}$ verlaufenden Korndurchmesser $d_{K,ortho}$, bestimmt auf halber Länge von $d_{K,max}$, ist (d.h. $R_K = d_{K,ortho}/d_{K,max}$). Aus dem arithmetischen Mittelwert der Formfaktoren $R_K$ der Körner erhält man den mittleren Korn-Formfaktor $R_a(Al_2O_3)$ des Aluminiumoxids. Geeignete Methoden, mit denen die Form der Aluminiumoxidkörner, beispielsweise bereits bei der Herstellung des Ausgangssubstrats, eingestellt werden können, sind dem Fachmann bekannt. Beispielsweise kann die Form der $Al_2O_3$-Körner durch Sinterdauer und Sintertemperatur bei der Herstellung des Ausgangssubstrats beeinflusst werden. $Al_2O_3$-Substrate, mit denen im finalen Kupfer-Keramik-Verbund der oben angegebene Formfaktor $R_a(Al_2O_3)$ realisiert werden kann, sind kommerziell erhältlich oder können über Standardverfahren erhalten werden.

Eine geeignete Dicke des Keramiksubstrats in einem Kupfer-Keramik-Verbund ist dem Fachmann bekannt. Üblicherweise weist das Keramiksubstrat über mindestens 70% seiner Fläche, bevorzugter mindestens 90% seiner Fläche eine Dicke im Bereich von 0.2-1.2 mm auf. Eine Dicke des Keramiksubstrates ist beispielsweise etwa 0,38 mm oder etwa 0,63 mm.

Bevorzugt sind die Dicke des Keramiksubstrats ($D_{cer}$) und der Medianwert $d_{50}$ der Korngrößen-Anzahlverteilung des Aluminiumoxids im Keramiksubstrat so ausgewählt, dass das Verhältnis $D_{cer}$ zu $d_{50}$ (d.h. $D_{cer} / d_{50}$) im Bereich von 0,001 bis 0,01, bevorzugter im Bereich von 0,002 bis 0,009, noch bevorzugter im Bereich von 0,004 bis 0,008 liegt. Hierzu wird die Dicke $D_{cer}$ des Keramiksubstrats an einer Stelle bestimmt und durch den Medianwert $d_{50}$ der Korngrößen-Anzahlverteilung des Aluminiumoxids dividiert. Bevorzugt liegt das Verhältnis $D_{cer}/d_{50}$ über mindestens 70%, bevorzugter mindestens 90% der Fläche des Keramiksubstrats im Bereich von 0,05 bis 0,40.

Optional kann das Aluminiumoxid noch mit Zirkonoxid ($ZrO_2$) verstärkt sein. Ein solches $ZrO_2$-verstärktes $Al_2O_3$ enthält, bezogen auf seine Gesamtmasse, das Zirkonoxid üblicherweise in einem Anteil von 0,5-30 Gew%. Das Zirkonoxid wiederum kann optional mit einem oder mehreren Dotieroxid(en), insbesondere Yttriumoxid, Calciumoxid, Ceroxid oder Magnesiumoxid, dotiert sein, üblicherweise in einem Anteil von bis zu 0,01 Gew% oder sogar bis zu 5 Gew%, bezogen auf die Gesamtmasse Zirkonoxid und Aluminiumoxid.

Bevorzugt enthält das Keramiksubstrat mindestens 65 Gew% $Al_2O_3$. Sofern kein $ZrO_2$ zur Verstärkung des $Al_2O_3$ vorliegt, kann das Keramiksubstrat beispielsweise zu mindestens 95 Gew%, bevorzugter 96 Gew% aus $Al_2O_3$ bestehen.

Sofern ein mit $ZrO_2$ verstärktes Aluminiumoxid verwendet wird (wobei das $ZrO_2$, wie oben erwähnt, optional noch dotiert ist), kann das Keramiksubstrat beispielsweise zu mindestens 96 Gew%, bevorzugter zu mindestens 98 Gew% aus diesem $ZrO_2$-verstärkten $Al_2O_3$ bestehen.

Das Keramiksubstrat kann beispielsweise eine Wärmeleitfähigkeit von $\geq 20$ W/mK, und/oder eine Biegebruchfestigkeit von $\geq 400$ MPa aufweisen.

Das Keramiksubstrat kann in Form eines Einzelsubstrats vorliegen. Alternativ ist es auch möglich, dass das Keramiksubstrat eine oder mehrere (bevorzugt geradlinig verlaufende) Sollbruchlinien aufweist, die das Keramiksubstrat in zwei oder mehr Bereiche unterteilen und zumindest in einem dieser Bereiche eine Beschichtung aus Kupfer oder einer Kupferlegierung aufgebracht ist. Hinsichtlich des Aufbaus eines solchen Mehrfachsubstrats mit Sollbruchlinien kann beispielhaft auf DE 43 19 944 A1 und DE 199 27 046 A1 verwiesen werden.

Geeignete Abmessungen (Länge x Breite) des Keramiksubstrats (entweder als Einzelsubstrat oder auch als Mehrfachsubstrat) in einem Metall-Keramik-Verbund sind dem Fachmann bekannt. Beispielsweise kann das Keramiksubstrat eine Abmessung, Länge x Breite, von (180-200 mm) x (130-150 mm) oder (180-200 mm) x (270-290 mm) aufweisen. Auch kleinere Abmessungen, beispielsweise (8-12 mm) x (8-12 mm), sind möglich.

In einer bevorzugten Ausführungsform weist das Aluminiumoxid Korngrößen im Bereich von $d_{min}(Al_2O_3)$ bis $d_{max}(Al_2O_3)$ auf, das Kupfer oder die Kupferlegierung weist Korngrößen im Bereich von $d_{min}(Cu)$ bis $d_{max}(Cu)$ auf, und die Verhältnisse von $d_{min}(Al_2O_3)$ zu $d_{max}(Cu)$ und von $d_{max}(Al_2O_3)$ zu $d_{min}(Cu)$ genügen folgenden Bedingungen (i) und (ii):

(i) $d_{min}(Al_2O_3) / d_{max}(Cu) \geq 1 \times 10^{-5}$ und

(ii) $2{,}5 \geq d_{max}(Al_2O_3) / d_{min}(Cu)$.

Noch bevorzugter genügen die Verhältnisse von $d_{min}(Al_2O_3)$ zu $d_{max}(Cu)$ und von $d_{max}(Al_2O_3)$ zu $d_{min}(Cu)$ folgenden Bedingungen (i) und (ii):

(i) $d_{min}(Al_2O_3) / d_{max}(Cu) \geq 0,001$ und

(ii) $1,5 \geq d_{max}(Al_2O_3) / d_{min}(Cu)$;

und am meisten bevorzugt folgenden Bedingungen (i) und (ii):

(i) $d_{min}(Al_2O_3) / d_{max}(Cu) \geq 0,002$ und

(ii) $1,0 \geq d_{max}(Al_2O_3) / d_{min}(Cu)$.

In einer besonders bevorzugten Ausführungsform sind

(i) $0,005 \geq d_{min}(Al_2O_3) / d_{max}(Cu) \geq 0,002$ und

(ii) $1,0 \geq d_{max}(Al_2O_3) / d_{min}(Cu) \geq 0,05$.

Damit kann zwischen der Metallbeschichtung und dem Keramiksubstrat eine feste Bindung realisiert werden kann, die auch unter häufigeren
Temperaturwechselbelastungen Bestand hält.

Wie oben bereits erwähnt, ist bevorzugt, dass $d_{min}(Cu) \geq 10\ \mu m$ und $d_{max}(Cu) \leq 300\ \mu m$, bevorzugter $d_{min}(Cu) \geq 15\ \mu m$ und $d_{max}(Cu) \leq 250\ \mu m$, noch bevorzugter $d_{min}(Cu) \geq 20\ \mu m$ und $d_{max}(Cu) \leq 210\ \mu m$, wobei $d_{min}(Cu)$ und $d_{max}(Cu)$ die minimalen bzw. maximalen Korngrößen des Kupfers sind.

In einer bevorzugten Ausführungsform liegt das Verhältnis von $d_{50}(Al_2O_3)$ zu $d_{50}(Cu)$ im Bereich von 0,008 bis 0,055, bevorzugter im Bereich von 0,010 bis 0,045. Damit kann eine weitere Optimierung der Adhäsion und Temperaturwechselbeständigkeit in dem Metall-Keramik-Verbund erzielt werden kann

In einer bevorzugten Ausführungsform weist das Kupfer oder die Kupferlegierung eine Anzahlverteilung der Korngrößen mit einem Medianwert $d_{50}$, einem arithmetischen Mittelwert $d_{arith}$ und einem Symmetriewert $S(Cu) = d_{50} / d_{arith}$ auf, das Aluminiumoxid weist eine Anzahlverteilung der Korngrößen mit einem Medianwert $d_{50}$, einem arithmetischen Mittelwert $d_{arith}$ und einem Symmetriewert $S(Al_2O_3)= d_{50} / d_{arith}$ auf, wobei $S(Al_2O_3)$ und $S(Cu)$ der folgenden Bedingung genügen:

$$0,7 \leq S(Al_2O_3) / S(Cu) \leq 1,4.$$

Bevorzugter genügen $S(Al_2O_3)$ und $S(Cu)$ der folgenden Bedingung:

$$0,74 \leq S(Al_2O_3) / S(Cu) \leq 1,35;$$

noch bevorzugter der folgenden Bedingung

$$0,80 \leq S(Al_2O_3) / S(Cu) \leq 1,25.$$

Damit lässt sich die Temperaturwechselbeständigkeit des Kupfer-Keramik-Verbunds verbessern.

Weiterhin betrifft die vorliegende Erfindung ein Modul, enthaltend zumindest einen Kupfer-Keramik-Verbund gemäß der obigen Beschreibung und einen oder mehrere Bonddrähte. Üblicherweise sind der Bonddraht oder die Bonddrähte mit der Beschichtung aus Kupfer oder Kupferlegierung verbunden. Geeignete Bondingverfahren zum Verbinden von Drähten mit einer Metallbeschichtung sind dem Fachmann bekannt. Das Modul kann außerdem ein oder mehrere elektronische Bauteile wie z.B. einen oder mehrere Chips enthalten.

Die Kornstrukturen des Aluminiumoxids des Keramiksubstrats sowie des Kupfers bzw. der Kupferlegierung der Metallbeschichtung werden im Rahmen der vorliegenden Erfindung folgendermaßen bestimmt:

Korngrößenverteilung des Aluminiumoxids des Keramiksubstrats

Von der Oberfläche des Keramiksubstrats wird eine rasterelektronenmikroskopische Aufnahme (REM-Aufnahme) gemacht. Eine spezielle Probenpräparation in Form eines Schliffbildes ist nicht erforderlich. Die REM-Aufnahme wird an einer Stelle des Keramiksubstrats gemacht, die zuvor mit Kupfer belegt war und durch Ätzen freigelegt wurde.

Die Korngrößen werden über ein Linienschnittverfahren bestimmt. Linienschnittverfahren sind dem Fachmann bekannt und werden beispielsweise in ASTM 112-13 beschrieben.

Die Vergrößerung wird so gewählt, dass durch das Linienraster mindestens 50 $Al_2O_3$-Körner geschnitten werden. Sofern das Keramiksubstrat noch Körner anderer chemischer Zusammensetzung, beispielsweise $ZrO_2$-Körner, enthält, lassen sich diese in der REM-Aufnahme mit Hilfe von Sekundärelektronenkontrast gut von den $Al_2O_3$-Körnern unterscheiden und werden somit nicht in die weiterfolgenden Berechnungen einbezogen.

In der vorliegenden Erfindung wurden jeweils 2 parallele Linien in x-Richtung und zwei parallele Linien in y-Richtung in die lichtmikroskopische Aufnahme gelegt. Die Linien unterteilen die Aufnahme jeweils in drei gleichmäßig breite Streifen. Dies ist in Figur 4 schematisch dargestellt. Wenn ein Korn von einer dieser Linien über eine Länge L hinweg geschnitten wird, so wird diese Länge L als Korngröße genommen. Für jedes von einer dieser Linien geschnittene Korn erhält man so eine Korngröße. Am Kreuzungspunkt zweier Linien erhält man für ein Korn zwei Werte, die beide in die Bestimmung der Korngrößenverteilung eingehen.

Aus den Korngrößen der geschnittenen Körner ergibt sich eine Korngrößenverteilung, aus der wiederum die $d_5$-, $d_{50}$- und $d_{95}$-Werte sowie der arithmetische Mittelwert $d_{arith}$ bestimmt werden können. Wie oben bereits erläutert und dem Fachmann allgemein bekannt ist, gilt für den $d_{50}$-Wert, der häufig auch als Medianwert bezeichnet wird, Folgendes: 50% der Körner weisen einen Durchmesser auf, der kleiner ist als der $d_{50}$-Wert. Analog gilt für den $d_5$-Wert, dass 5% der Körner einen Durchmesser aufweisen, der kleiner ist als dieser $d_5$-Wert, und für den $d_{95}$-Wert gilt, dass 95% der Körner einen Durchmesser aufweisen, der kleiner ist als dieser $d_{95}$-Wert. Der arithmetische Mittelwert der Korngrößenverteilung ergibt sich aus der Summe der Korngrößen der einzelnen Körner dividiert durch die Anzahl der geschnittenen Körner.

### Korngrößenverteilung des Kupfers oder der Kupferlegierung

Von der Oberfläche der Beschichtung aus Kupfer oder einer Kupferlegierung (parallel zur beschichteten Substratoberfläche) wird eine lichtmikroskopische Aufnahme gemacht. Eine spezielle Probenpräparation in Form eines Schliffbildes ist nicht erforderlich.

Die Korngrößen werden über ein Linienschnittverfahren bestimmt. Linienschnittverfahren sind dem Fachmann bekannt und werden beispielsweise in ASTM 112-13 beschrieben.

Die Vergrößerung wird so gewählt, dass durch das Linienraster mindestens 50 Körner geschnitten werden.

Hinsichtlich der weiteren Auswertung über das Linienschnittverfahren kann auf die oben bei dem Aluminiumoxid gemachten Ausführungen verwiesen werden.

Sowohl die Korngrößen des Kupfers bzw. der Kupferlegierung wie auch die Korngrößen des $Al_2O_3$ werden also in einer Ebene bestimmt, die parallel zur beschichteten Substratoberfläche verläuft oder koplanar mit dieser ist.

### Formfaktor einzelner Körner, mittlerer Korn-Formfaktor

#### Aluminiumo xid

Es wird die REM-Aufnahme herangezogen, die auch bei der Bestimmung der Korngrößenverteilung verwendet wurde.

Für die Bestimmung des Formfaktors eines individuellen Korns wird folgendermaßen vorgegangen: Es wird dessen längste Abmessung $d_{K,max}$ bestimmt. Anschließend wird auf halber Länge von $d_{K,max}$ der senkrecht zu $d_{K,max}$ verlaufende Durchmesser $d_{K,ortho}$ des Korns bestimmt. Der Formfaktor des individuellen Korns $R_K$ ergibt sich aus dem Verhältnis von $d_{K,ortho}$ zu $d_{K,max}$, d.h. $R_K = d_{K,ortho} / d_{K,max}$.

Dies ist schematisch in Figur 3 anhand eines Korns mit elliptischer Kornstruktur dargestellt. Je mehr sich die Form eines Korns in seiner zweidimensionalen Projektion derjenigen eines Kreises annähert, desto mehr nähert sich der Formfaktor des Korns dem Wert 1,0 an. Der Formfaktor ist daher auch ein Maß für die Kreisförmigkeit/Rundheit der Körner.

Der Formfaktor wird für mindestens 50 Körner der REM-Aufnahme bestimmt. Es werden üblicherweise die Körner ausgewertet, die auch im Linienschnittverfahren von den Linien geschnitten wurden.

Der mittlere Korn-Formfaktor des Aluminiumoxids ergibt sich dann aus dem arithmetischen Mittelwert der Formfaktoren der individuellen $Al_2O_3$-Körner (d.h. Summe der individuellen Formfaktoren dividiert durch die Anzahl der untersuchten Körner).

#### Kupfer, Kupferlegierung

Es wird die lichtmikroskopische Aufnahme herangezogen, die auch bei der Bestimmung der Korngrößenverteilung verwendet wurde.

Hinsichtlich der Bestimmung des Formfaktors individueller Körner sowie des mittleren Korn-Formfaktors des Kupfers oder der Kupferlegierung kann auf die oben beim $Al_2O_3$ gemachten Ausführungen verwiesen werden.

Sowohl die Korn-Formfaktoren des Kupfers bzw. der Kupferlegierung wie auch die Korn-Formfaktoren des $Al_2O_3$ werden also in einer Ebene bestimmt, die parallel zur beschichteten Substratoberfläche verläuft oder koplanar mit dieser ist.

Nachfolgend wird ein Bonding-Verfahren beschrieben, welches zur Herstellung der erfindungsgemäßen Kupfer-Keramik-Substrate bevorzugt verwendet wird:

Ein typischer Verfahrensprozess, der im Rahmen der vorliegenden Erfindung bevorzugt für das Aufbringen der Kupferbeschichtung auf das Keramiksubstrat verwendet wird, ist beispielsweise aus den Druckschriften US 3,744,120, US 3,994,430, EP 0 085 914 A oder der DE 23 19 854 A bekannt, deren entsprechende Offenbarung durch Bezugnahme in die vorliegende Erfindung eingeschlossen wird.

Diesen dort offenbarten Herstellungsverfahren ist beispielsweise im Rahmen des Direct-Copper-Bonding-Prozesses (DCB-Prozess) gemeinsam, dass eine Kupferfolie zunächst derartig oxidiert wird, dass sich eine im Wesentlichen gleichmäßige Kupferoxidschicht ergibt. Die resultierende Kupferfolie wird dann auf ein Keramik-Substrat positioniert und der Verbund aus Keramik-Substrat und Kupferfolie wird auf eine Prozess- bzw. Bondtemperatur zwischen etwa 1025 und 1083 °C erwärmt, wodurch es zu der Ausbildung eines metallisierten Keramik-Substrats kommt. Die Kupferfolie stellt nach dem Bonden somit eine Beschichtung dar. Abschließend wird das resultierende metallisierte Keramik-Substrat abgekühlt.

Die Durchführung des Verbindens von Keramik-Substrat und Kupferfolie erfolgt in einem Ofen, wobei im Allgemeinen sogenannte Bondöfen eingesetzt werden. Entsprechende Bondöfen, häufig auch als Tunnelöfen bezeichnet, umfassen unter anderem einen langgestreckten tunnelartigen Ofenraum (auch Muffel genannt) sowie eine Transportvorrichtung mit einem Transportelement beispielsweise in Form eines flexiblen und hitzebeständigen Transportbandes zum Transportieren des Behandlungsgutes durch den mit einer Heizeinrichtung beheizten Ofenraum. Die Keramik-Substrate werden zusammen mit der Kupferfolie auf einen Träger auf dem Transportband positioniert und durchlaufen anschließend in dem Bondofen durch das Transportband angetrieben einen Heizbereich, in welchem die erforderliche Bondtemperatur erreicht wird. Am Ende des Bondprozesses wird der resultierende Verbund aus Keramik-Substrat und Kupferfolie gemäß der Erfindung wieder abgekühlt.

Dieses Verfahren kann grundsätzlich zur Herstellung von einseitig metallisierten Keramik-Substraten sowie auch zur Herstellung von doppelseitig metallisierten Substraten angewendet werden. Dabei erfolgt die Herstellung von doppelseitig metallisierten Substraten in der Regel über einen zweistufigen Bondprozess, d.h. mittels eines zweistufigen Single-Layer-Prozesses (SLB-Verfahren). Im Rahmen der Erfindung wird bevorzugt ein zweistufiger Bondprozess verwendet.

Bei diesem zweistufigen Bondprozess zur Herstellung von doppelseitig metallisierten Keramik-Substraten gemäß der Erfindung wird die Keramik in zwei Ofendurchläufen mit den Kupferfolien auf den gegenüberliegenden Seiten des Keramik-Substrats verbunden.

Für diesen Zweck wird zunächst ein Keramik-Substrat auf einen Träger positioniert und anschließend auf der obenliegenden, d.h. auf der dem Träger abgewandten Seite, mit einer Kupferfolie bedeckt. Durch Wärmeeinwirkung wird diese Seite des Keramik-Substrats mit der Metallschicht verbunden und anschießend die resultierende Anordnung abgekühlt. Anschließend wird das Substrat umgedreht und in einem zweiten Bondschritt wird die andere Seite des Substrats auf gleiche Weise mit einer Metallschicht, d.h. der Kupferfolie, versehen.

Es ist möglich Einzel-Teil-Karten herzustellen oder Großkarten, welche mehrere herausbrechbaren Einzelteil-Karten aufweisen.

**Beispiele**

Die nachfolgenden Beispiele zeigen, wie die Temperaturwechselbeständigkeit des Kupfer-Keramik-Verbunds verbessert werden kann, wenn die mittleren Formfaktoren des Kupfers und des $Al_2O_3$ einander angenähert werden.

Es wurden 3 Kupfer-Keramik-Proben über ein DCB-Verfahren hergestellt: Kupfer-Keramik-Verbund 1, nachfolgend *"K-K-V 1"* (erfindungsgemäß) Kupfer-Keramik-Verbund 2, nachfolgend *"K-K-V 2"* (Vergleichsprobe) Kupfer-Keramik-Verbund 3, nachfolgend *"K-K-V 3"* (Vergleichsprobe)

In jedem dieser drei Kupfer-Keramik-Verbunde wurde sowohl die Ober- wie auch die Unterseite des Keramiksubstrats mit einer Kupferbeschichtung versehen. Die Kupferbeschichtung wurde dabei zunächst mit einer Seite des Keramiksubstrates mittels des SLB-Verfahrens gebondet. Anschließend wurde die gegenüberliegende Seite des Keramiksubstrates mittels des SLB-Verfahrens mit einer weiteren Kupferbeschichtung, so dass ein Kupfer-Keramik-Substrat entsteht, bei dem auf beiden Seiten der Keramik eine Kupferfolie gebondet ist. Jeweils eine der beiden Kupferbeschichtungen wurde in jeder Probe über ein Ätzverfahren nachfolgend strukturiert (gleiche Strukturierung für alle Proben). In allen Beispielen bestanden die Substrate zu 96 Gew% aus $Al_2O_3$.

In jedem dieser 3 Kupfer-Keramik-Verbunde wies das Keramiksubstrat folgende Abmessungen auf:

Dicke des Keramiksubstrats: 0,38 mm;
Länge x Breite des Keramiksubstrats: 190 x 140 mm$^2$

Die Kupferbeschichtung wies jeweils eine Dicke von 0,3 mm auf.

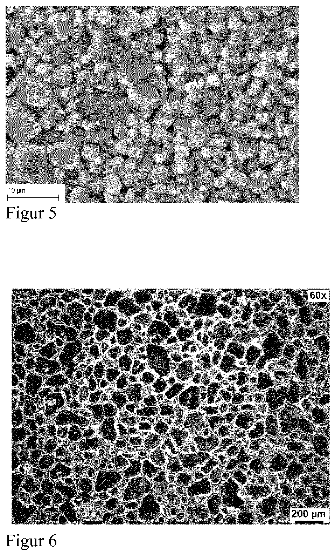

Figur 5 zeigt eine REM-Aufnahme der Oberfläche des Keramiksubstrats von K-K-V 1, mittels der die Al$_2$O$_3$-Kornstruktur bestimmt wurde.

Figur 6 zeigt eine lichtmikroskopische Aufnahme von der Oberfläche der Kupferbeschichtung von K-K-V 1, mittels der die Kupfer-Kornstruktur bestimmt wurde.

Für jede dieser 3 Proben wurde die Temperaturwechselbeständigkeit des Metall-Keramik-Verbunds bestimmt, und zwar nach folgender Methode:

Zur Ermittlung der Temperaturwechselbeständigkeit des Kupfer-Keramik-Substrats wird bevorzugt ein Einzel-Teil-Substrat aus einer Großkarte herausgebrochen. Das Einzelteilsubtrat wurde in einer dem Fachmann bekannten Vorrichtung einem Temperatur-Wechsel-Zyklus unterzogen, der sich zusammensetzt aus:

- Auslagerung bei 150 °C (bevorzugt in einer ersten Kammer eines Temperaturwechselschranks) für 15 Minuten

- Auslagerung bei - 40 °C (minus 40 °C) (bevorzugt in einer zweiten Kammer des Temperaturwechselschranks) für 15 Minuten

- , wobei zwischen der Verlagerung von einer Kammer in die andere Kammer eine Transferzeit von 15 Sekunden liegt.

Im Rahmen von 5 Zyklen (Auslagerung 150 °C zu -40 °C und zurück entspricht einem Zyklus) wurde jeweils mittels Ultraschallmikroskop die Fläche der Verbindung an der Grenzfläche zwischen Kupfer und Keramik auf Delamination untersucht.

In der nachfolgenden Tabelle 1 werden für die getesteten Verbunde K-K-V 1, K-K-V 2 und K-K-V 3 die jeweiligen Verhältnisse der mittleren Korn-Formfaktoren (d.h. $R_a$(Al$_2$O$_3$) / $R_a$(Cu)) sowie die Ergebnisse der Temperaturwechselbeständigkeitstests zusammengefasst:

Tabelle 1: Temperaturwechselbeständigkeit in Abhängigkeit von $R_a$(Al$_2$O$_3$) / $R_a$(Cu)

| | | Temperaturwechselbeständigkeit |
|---|---|---|
| Probe K-K-V 1 (erfindungs-gemäß) | $R_a$(Al$_2$O$_3$) / $R_a$(Cu): 1,0 | + |
| Probe K-K-V 2 (Vergleich) | $R_a$(Al$_2$O$_3$) / $R_a$(Cu): 0,2 | - |
| Probe K-K-V 3 (Vergleich) | $R_a$(Al$_2$O$_3$) / $R_a$(Cu): 2,8 | - |

Wie die Beispiele zeigen, kann die Temperaturwechselbeständigkeit des Kupfer-Keramik-Verbunds verbessert werden, wenn die durchschnittliche Form der Körner und damit die mittleren Korn-Formfaktoren des Kupfers und des Al$_2$O$_3$ einander angeglichen werden.

**Patentansprüche**

1. Kupfer-Keramik-Verbund, umfassend

   - ein Keramiksubstrat, das Aluminiumoxid enthält,
   - eine auf dem Keramiksubstrat vorliegende Beschichtung aus Kupfer oder einer Kupferlegierung, die über ein DCB-Verfahren auf das Keramiksubstrat aufgebracht wird,

   wobei

   die Körner des Aluminiumoxids jeweils einen maximalen Durchmesser $d_{Kmax}$, einen senkrecht zu $d_{K,max}$ verlaufenden Durchmesser $d_{K,ortho}$, bestimmt auf halber Länge von $d_{K,max}$, und einen Formfaktor $R_K$(Al$_2$O$_3$)= $d_{K,ortho}$ / $d_{K,max}$ aufweisen und das Aluminiumoxid einen mittleren Korn-Formfaktor $R_a$(Al$_2$O$_3$), bestimmt als arithmetischer Mittelwert aus den Formfaktoren $R_K$(Al$_2$O$_3$) der Körner des Aluminiumoxids, aufweist,
   die Körner des Kupfers oder der Kupferlegierung jeweils einen maximalen Durchmesser $d_{K,max}$, einen senkrecht zu $d_{K,max}$ verlaufenden Durchmesser $d_{K,ortho}$, bestimmt auf halber Länge von $d_{K,max}$, und einen Formfaktor

$R_K(Cu) = d_{K,ortho} / d_{K,max}$ aufweisen und das Kupfer oder die Kupferlegierung einen mittleren Korn-Formfaktor $R_a(Cu)$, bestimmt als arithmetischer Mittelwert aus den Formfaktoren $R_K(Cu)$ der Körner des Kupfers oder der Kupferlegierung, aufweist,

wobei die mittleren Korn-Formfaktoren des Aluminiumoxids und des Kupfers oder der Kupferlegierung der folgenden Bedingung genügen:

$$0{,}5 \leq R_a(Al_2O_3) / R_a(Cu) \leq 2{,}0.$$

2. Kupfer-Keramik-Verbund nach Anspruch 1, wobei das Kupfer oder die Kupferlegierung Korngrößen im Bereich von 10 $\mu$m bis 300 $\mu$m, bevorzugter im Bereich von 15 $\mu$m bis 250 $\mu$m, noch bevorzugter im Bereich von 20 $\mu$m bis 210 $\mu$m aufweist.

3. Kupfer-Keramik-Verbund nach Anspruch 1 oder 2, wobei das Aluminiumoxid Korngrößen im Bereich von 0,01 $\mu$m bis 25 $\mu$m, bevorzugter im Bereich von 0,3 $\mu$m bis 23 $\mu$m, noch bevorzugter im Bereich von 0,5 $\mu$m bis 20 $\mu$m aufweist.

4. Kupfer-Keramik-Verbund nach einem der vorstehenden Ansprüche, wobei das Verhältnis des mittleren Korn-Formfaktors des Aluminiumoxids zu dem mittleren Korn-Formfaktor des Kupfers oder der Kupferlegierung im Bereich von 0,75-1,50, bevorzugter im Bereich von 0,80-1,20 liegt.

5. Kupfer-Keramik-Verbund nach einem der vorstehenden Ansprüche, wobei das Keramiksubstrat zu mindestens 65 Gew% aus dem Aluminiumoxid besteht.

6. Kupfer-Keramik-Verbund nach einem der vorstehenden Ansprüche, wobei die Beschichtung aus Kupfer oder einer Kupferlegierung zur Ausbildung von elektrischen Kontaktflächen zumindest teilweise eine Strukturierung aufweist.

7. Kupfer-Keramik-Verbund nach einem der vorstehenden Ansprüche, wobei die Beschichtung aus Kupfer oder einer Kupferlegierung über mindestens 70% ihrer Fläche eine Dicke im Bereich von 0,2-1,2 mm aufweist; und/oder das Keramiksubstrat über mindestens 70% seiner Fläche eine Dicke im Bereich von 0,2-1,2 mm aufweist.

8. Modul, enthaltend zumindest einen Kupfer-Keramik-Verbund gemäß einem der Ansprüche 1-7 und einen oder mehrere Bonddrähte.

**Claims**

1. Copper-ceramic composite comprising

   - a ceramic substrate containing aluminum oxide,
   - a coating of copper or a copper alloy present on the ceramic substrate, which coating is applied by a DCB process to the ceramic substrate,

   wherein

   the grains of the aluminum oxide each have a maximum diameter $d_{Kmax}$, a diameter $d_{K,ortho}$ running perpendicular to $d_{K,max}$, determined on half the length of $d_{K,max}$, and a shape factor $R_K(Al_2O_3) = d_{K,ortho} / d_{K,max}$ and the aluminum oxide has an average grain shape factor $R_a(Al_2O_3)$, determined as arithmetic mean of the shape factors $R_K(Al_2O_3)$ of the grains of the aluminum oxide,
   the grains of the copper or of the copper alloy each have a maximum diameter $d_{K,max}$, a diameter $d_{K,ortho}$ running perpendicular to $d_{K,max}$, determined on half the length of $d_{K,max}$, and a shape factor $R_K(Cu) = d_{K,ortho} / d_{K,max}$ and the copper or the copper alloy has an average grain shape factor $R_a(Cu)$, determined as arithmetic mean of the shape factors $R_K(Cu)$ of the grains of the copper or of the copper alloy,
   where the average grain shape factors of the aluminum oxide and of the copper or of the copper alloy satisfy the following condition:

   $$0.5 \leq R_a(Al_2O_3) / R_a(Cu) \leq 2.0.$$

**2.** Copper-ceramic composite according to Claim 1, wherein the copper or the copper alloy has grain sizes in the range from 10 $\mu$m to 300 $\mu$m, more preferably in the range from 15 $\mu$m to 250 $\mu$m, even more preferably in the range from 20 $\mu$m to 210 $\mu$m.

**3.** Copper-ceramic composite according to Claim 1 or 2, wherein the aluminum oxide has grain sizes in the range from 0.01 $\mu$m to 25 $\mu$m, more preferably in the range from 0.3 $\mu$m to 23 $\mu$m, even more preferably in the range from 0.5 $\mu$m to 20 $\mu$m.

**4.** Copper-ceramic composite according to any of the preceding claims, wherein the ratio of the average grain shape factor of the aluminum oxide to the average grain shape factor of the copper or of the copper alloy is in the range of 0.75-1.50, more preferably in the range of 0.80-1.20.

**5.** Copper-ceramic composite according to any of the preceding claims, wherein the ceramic substrate consists to an extent of at least 65% by weight of the aluminum oxide.

**6.** Copper-ceramic composite according to any of the preceding claims, wherein the coating of copper or a copper alloy at least partly has structuring to form electrical contact areas.

**7.** Copper-ceramic composite according to any of the preceding claims, wherein the coating of copper or a copper alloy has a thickness in the range of 0.2-1.2 mm over at least 70% of its area; and/or the ceramic substrate has a thickness in the range of 0.2-1.2 mm over at least 70% of its area.

**8.** Module containing at least one copper-ceramic composite according to any of Claims 1-7 and one or more bond wires.

**Revendications**

**1.** Composite cuivre-céramique, comprenant :

- un substrat en céramique, qui contient de l'oxyde d'aluminium,
- un revêtement en cuivre ou en un alliage de cuivre présent sur le substrat en céramique, qui est appliqué par un procédé DCB sur le substrat en céramique,

les grains de l'oxyde d'aluminium présentant chacun un diamètre maximal $d_{K,max}$, un diamètre perpendiculaire à $d_{K,max}$, $d_{K,ortho}$, déterminé à mi-longueur de $d_{K,max}$, et un facteur de forme $R_K(Al_2O_3) = d_{K,ortho}/d_{K,max}$. et l'oxyde d'aluminium présentant un facteur de forme de grain moyen $R_a(Al_2O_3)$, déterminé en tant que valeur moyenne arithmétique à partir des facteurs de forme $R_K(Al_2O_3)$ des grains de l'aluminium, les grains du cuivre ou de l'alliage de cuivre présentant chacun un diamètre maximal $d_{K,max}$, un diamètre perpendiculaire à $d_{K,max}$, $d_{K,ortho}$, déterminé à mi-longueur de $d_{K,max}$, et un facteur de forme $R_K(Cu) = d_{K,ortho}/d_{K,max}$, et le cuivre ou l'alliage de cuivre présentant un facteur de forme de grain moyen $R_a(Cu)$, déterminé en tant que valeur moyenne arithmétique à partir des facteurs de forme $R_K(Cu)$ des grains du cuivre ou de l'alliage de cuivre, les facteurs de forme de grain moyen de l'oxyde d'aluminium et du cuivre ou de l'alliage de cuivre satisfaisant la condition suivante :

$$0,5 \leq R_a(Al_2O_3)/R_a(Cu) \leq 2,0.$$

**2.** Composite cuivre-céramique selon la revendication 1, dans lequel le cuivre ou l'alliage de cuivre présente des tailles de grain dans la plage allant de 10 $\mu$m à 300 $\mu$m, de manière davantage préférée dans la plage allant de 15 $\mu$m à 250 $\mu$m, de manière encore davantage préférée dans la plage allant de 20 $\mu$m à 210 $\mu$m.

**3.** Composite cuivre-céramique selon la revendication 1 ou 2, dans lequel l'oxyde d'aluminium présente des tailles de grain dans la plage allant de 0,01 $\mu$m à 25 $\mu$m, de manière davantage préférée dans la plage allant de 0,3 $\mu$m à 23 $\mu$m, de manière encore davantage préférée dans la plage allant de 0,5 $\mu$m à 20 $\mu$m.

**4.** Composite cuivre-céramique selon l'une quelconque des revendications précédentes, dans lequel le rapport entre le facteur de forme de grain moyen de l'oxyde d'aluminium et le facteur de forme de grain moyen du cuivre ou de l'alliage de cuivre se situe dans la plage allant de 0,75 à 1,50, de manière davantage préférée dans la plage allant de 0,80 à 1,20.

5. Composite cuivre-céramique selon l'une quelconque des revendications précédentes, dans lequel le substrat en céramique est constitué par au moins 65 % en poids de l'oxyde d'aluminium.

6. Composite cuivre-céramique selon l'une quelconque des revendications précédentes, dans lequel le revêtement en cuivre ou en un alliage de cuivre présente au moins partiellement une structuration pour la formation de surfaces de contact électriques.

7. Composite cuivre-céramique selon l'une quelconque des revendications précédentes, dans lequel le revêtement en cuivre ou en un alliage de cuivre présente sur au moins 70 % de sa surface une épaisseur dans la plage allant de 0,2 à 1,2 mm ; et/ou le substrat en céramique présente sur au moins 70 % de sa surface une épaisseur dans la plage allant de 0,2 à 1,2 mm.

8. Module, contenant au moins un composite cuivre-céramique selon l'une quelconque des revendications 1 à 7, et un ou plusieurs fils de connexion.

**Figuren**

Figur 1

Figur 2

Figur 3

Figur 4

Figur 5

Figur 6

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 3744120 A
- DE 2319854
- DE 4004844
- DE 4318241 A1
- DE 102012110322
- DE 102004050792
- DE 102004012231 B4
- DE 4004844 C1
- DE 4319944 A1
- DE 19927046 A1
- US 3994430 A
- EP 0085914 A
- DE 2319854 A